# EUROPEAN PATENT APPLICATION

(11) **EP 3 482 868 A2**
(43) Date of publication of application: **15.05.2019**
(21) Application number: 18206324.8
(22) Date of filing: 14.11.2018
(51) Int. Cl.: B23K 26/0622, B23K 26/064, B23K 26/082, B23K 26/364, B23K 26/06, H01L 51/56, B23K 103/02

(54) **APPARATUS FOR MANUFACTURING A MASK AND METHOD FOR MANUFACTURING A MASK**

(30) Priority: 14.11.2017 KR 20170151271
(71) Applicant: Samsung Display Co., Ltd., Gyeonggi-Do (KR)
(72) Inventor: KIM, Wonyong, Gyeonggi-do (KR); HAN, Gyoowan, Gyeonggi-do (KR); KANG, Taekkyo, Gyeonggi-do (KR); MYOUNG, Seungho, Gyeonggi-do (KR); OH, Taekil, Seoul (KR)
(74) Representative: Mounteney, Simon James

(57) **Abstract**

An apparatus (2000) for manufacturing a mask (MS) is provided. The apparatus includes a stage (700) on which a pre-mask is disposed, and a laser irradiation device (600) including a laser generation member (610), an optical system (620) for controlling a shape of a laser beam, and a scanner (630) for adjusting a path of a laser beam that has the shape controlled by the optical system. The pre-mask (MC) includes a first pattern groove (PT1,PT3) defined on a front surface (S1,S3) and a second pattern groove (PT2,PT4) defined on a rear surface (S2,S4) that corresponds to the front surface. A first portion (M1,M3) and a second portion (M2,M4) are defined in a first direction that is a thickness direction of the pre-mask. The laser beam with the controlled shape is irradiated to the second portion of the pre-mask in a second direction crossing the first direction, a mask having an opening, in which the second portion is removed, is provided.

## Description

### BACKGROUND

The present disclosure herein relates to an apparatus for manufacturing a mask and a method for manufacturing a mask.

Display devices output a video or an image using pixels that have pixel areas, so as to provide various kinds of visual information to a user. Organic light emitting display devices of the display devices have a wide viewing angle, excellent contrast, and fast response speed. The formation of the Pixel areas of these organic light emitting display devices may employ a deposition process to deposit a deposition material. As one example, an organic material is deposited on a substrate through a fine metal mask (FMM) to provide a thin film having a desired pattern.

As the demand for high resolution display devices increases, an opening of a mask through which the deposition material is transferred also requires a precise manufacturing process. The opening may be made by etching one surface and the other surface of the mask so as to provide a precise opening, but a protrusion is made during the etching process of the both surfaces, which causes the shadow effect that makes it impossible to perform the deposition of the desired shape and size during the deposition process.

### SUMMARY

An aspect of the present disclosure relates to an apparatus for manufacturing a mask, so as to provide a mask for solving the above-described limitation.

An aspect of the present disclosure provides an apparatus for manufacturing a mask, which enables a more precise deposition.

An embodiment of the inventive concept provides an apparatus for manufacturing a mask, the apparatus including a stage on which a pre-mask is disposed such that a front surface of the pre-mask faces the stage (e.g., faces downward), and a laser irradiation device including a laser generation member configured to irradiate a laser beam to melt or remove a portion of the pre-mask, an optical system configured to receive the laser beam and control a shape of the laser beam, and a scanner configured to adjust a path of the laser beam that has the shape controlled by the optical system, . Here, the pre-mask includes a first portion having a first pattern groove provided through the front surface and a second portion having a second pattern groove provided through a rear surface that faces oppositely away from the front surface, and the first portion and the second portion are arranged in a first direction that is a thickness direction of the pre-mask, and the laser beam with the controlled shape is irradiated onto the second portion of the pre-mask while being steered in a second direction crossing the first direction to remove the second portion to provide a mask having an opening.

In an embodiment, a width of the first pattern groove is greater than a width of the second pattern groove.

In an embodiment, the width of the first pattern groove has a maximum width ranging from about 15 µm to about 40 µm.

In an embodiment, the first pattern groove and the second pattern groove respectively, have widths that decrease gradually from the front surface and the rear surface of the pre-mask in the thickness direction of the pre-mask.

In an embodiment, a surface of the mask exposed by removing the second portion has an uneven surface shape.

In an embodiment, the laser beam may be a femto-second laser.

In an embodiment, the laser beam with the controlled shape may have a flat-top shape.

In an embodiment, the scanner may include a first mirror configured to reflect the laser beam with the controlled shape, a first driving part configured to rotate the first mirror, a second mirror configured to transmit the laser beam with the controlled shape, which is reflected from the first mirror, to the pre-mask, a second driving part configured to rotate the second mirror, and a lens configured to collect the laser beam with the controlled shape, which is reflected from the second mirror.

In an embodiment, a shape of an inner surface on a cross-section of each of the first pattern groove and the second pattern groove is formed of either a curved line or a straight line.

In an embodiment of the inventive concept, an apparatus for manufacturing a mask includes: a stage on which a pre-mask is disposed, the pre-mask having a first surface and a second surface that face oppositely away from each other; and a laser irradiation device including a laser generation member configured to irradiate a laser beam to melt or remove a portion of the pre-mask, an optical system configured to receive the laser beam and control a shape of the laser beam, and a scanner configured to adjust a path of the laser beam that has the shape controlled by the optical system. Here, the pre-mask has a first thickness, the pre-mask includes a pattern portion having a protrusion, the pattern portion being provided in a first direction that is a thickness direction of the pre-mask, and the laser beam with the controlled shape is irradiated on any one of the first surface and the second surface of the pre-mask to provide a mask having a second thickness different from the first thickness and having an opening in which the protrusion is removed.

In an embodiment, the first thickness may be greater than the second thickness.

In an embodiment, the width of the opening may have a maximum width ranging from about 15 µm to about 40 µm.

In an embodiment, a shape of an inner surface of the pattern portion on a cross-section is formed of either a curved line or a straight line.

In an embodiment, when the shape of the inner surface on a cross section of the pattern portion is the curved line, a radius of curvature may decrease gradually from each of the first surface and the second surface of the mask toward the protrusion.

In an embodiment, wherein a surface of the mask -- exposed by removing the protrusion -- has an uneven surface shape.

In an embodiment, the laser beam may be a femto-second laser beam.

In an embodiment, the laser beam with the controlled shape may have a flat-top shape.

In an embodiment, the scanner may include a first mirror configured to reflect the laser beam with the controlled shape, a first driving part configured to rotate the first mirror, a second mirror configured to transmit the laser beam with the controlled shape, which is reflected from the first mirror, to the mask, a second driving part configured to rotate the second mirror, and a lens configured to collect the laser beam with the controlled shape, which is reflected from the second mirror.

In an embodiment of the inventive concept, a method for manufacturing a mask includes performing a first etching in which, for a pre-mask having a first surface and a second surface that face oppositely away from each other, a first pattern groove having a first depth is provided through the first surface, performing a second etching in which a second pattern groove having a second depth is provided through the second surface; and providing a mask that has a front surface having an even surface shape and a rear surface having an uneven surface shape, by removing any one of the first surface and the second surface of the pre-mask, wherein the rear surface is defined by removing any one of the first surface and the second surface.

In an embodiment, the providing of the mask may include irradiating a laser beam onto the front surface of the pre-mask and removing any one of the first surface and the second surface of the pre-mask.

At least some of the above features that accord with the invention, and other features according to the invention, are set-out in the claims.

### BRIEF DESCRIPTION OF THE FIGURES

The drawings illustrate embodiments of the inventive concept and, together with the description, serve to explain principles of the inventive concept. In the drawings:
FIG. 1 is a schematic view of deposition equipment using a mask according to an embodiment of the inventive concept;
FIG. 2 is a cross-sectional view illustrating a portion of a pixel area in a substrate according to an embodiment of the inventive concept;
FIG. 3 is a perspective view of equipment for manufacturing a mask according to an embodiment of the inventive concept;
FIGS. 4A and 4B are cross-sectional views of a mask according to an embodiment of the inventive concept;
FIGS. 5A and 5B are cross-sectional views of a mask according to an embodiment of the inventive concept;
FIGS. 6A and 6B illustrate shapes of laser according to an embodiment of the inventive concept;
FIG. 7 is a cross-sectional view of a scanner according to an embodiment of the inventive concept;
FIG. 8 is a block diagram illustrating a method for manufacturing a mask according to an embodiment of the inventive concept; and
FIGS. 9A to 9F are views illustrating a process of a method for manufacturing a mask according to an embodiment of the inventive concept.

### DETAILED DESCRIPTION

Since an embodiment of the inventive concept may have various modifications and diverse shapes, particular embodiments are illustrated in the drawings and are described in the detailed description. However, the scope of the present invention is not limited to the disclosure of these particular embodiments.

When explaining each of the drawings, like reference numerals are used for referring to like elements. In the accompanying drawings, the dimensions of structures are scaled up or down from the real ones for clarity of the present disclosure. It will be understood that although the terms of first and second are used herein to describe various elements, these elements should not be limited by these terms. Terms are only used to distinguish one component from other components. For example, a first element can be referred to as a second element, and similarly a second element can be referred to as a first element without departing from the scope of the present disclosure. The terms of a singular form may include plural forms unless definitely indicating a particular case in terms of the context.

In the application, it will be understood that the meaning of "include" or "comprise" specifies the presence of a property, a fixed number, a step, a process, an element, a component, or a combination thereof disclosed in the specification but does not exclude the possibility of the presence or addition of one or more of properties, fixed numbers, steps, processes, elements, components, or combinations thereof in advance.

For an embodiment of the inventive concept so as to achieve the above-described purpose, certain embodiments of the inventive concept will be described in more detail with reference to the accompanying drawings hereinafter.

Spatially relative terms, such as "beneath", "below", "lower", "under", "above", "upper" and the like, may be used herein for ease of description to describe one element or feature's relationship to another element(s) or feature(s) as illustrated in the figures. It will be understood that the spatially relative terms are intended to encompass different orientations of the device in use or in operation, in addition to the orientation depicted in the figures. For example, if the device in the figures is turned over, elements described as "below" or "beneath" or "under" other elements or features would then be oriented "above" the other elements or features. Thus, the example terms "below" and "under" can encompass both an orientation of above and below. The device may be otherwise oriented (e.g., rotated 90 degrees or at other orientations) and the spatially relative descriptors used herein should be interpreted accordingly. In addition, it will also be understood that when a layer is referred to as being "between" two layers, it can be the only layer between the two layers, or one or more intervening layers may also be present.

The use of "may" when describing embodiments of the inventive concept refers to "one or more embodiments of the inventive concept."

It will be understood that when an element or layer is referred to as being "on", "connected to", "coupled to", or "adjacent to" another element or layer, it can be directly on, connected to, coupled to, or adjacent to the other element or layer, or one or more intervening elements or layers may be present. In contrast, when an element or layer is referred to as being "directly on," "directly connected to", "directly coupled to", or "immediately adjacent to" another element or layer, there are no intervening elements or layers present.

As used herein, the term "substantially," "about," and similar terms are used as terms of approximation and not as terms of degree, and are intended to account for the inherent deviations in measured or calculated values that would be recognized by those of ordinary skill in the art. Also, any numerical range recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein.

As used herein, the terms "use," "using," and "used" may be considered synonymous with the terms "utilize," "utilizing," and "utilized," respectively.

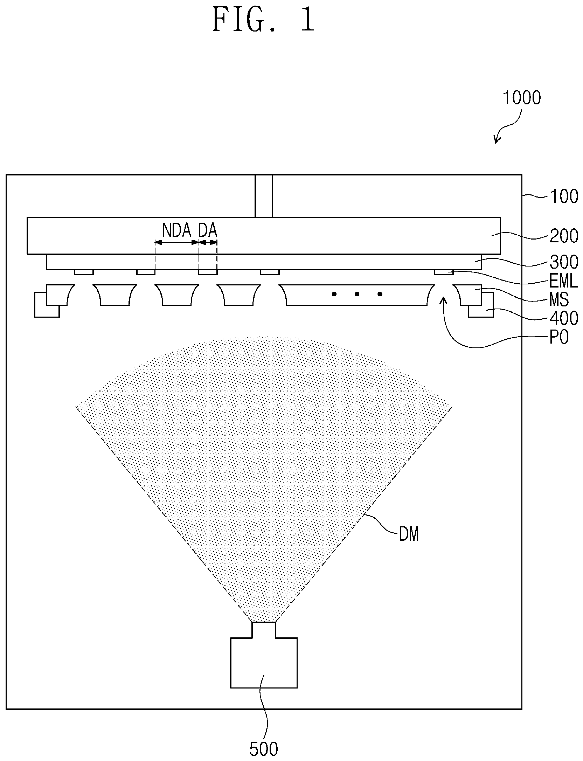

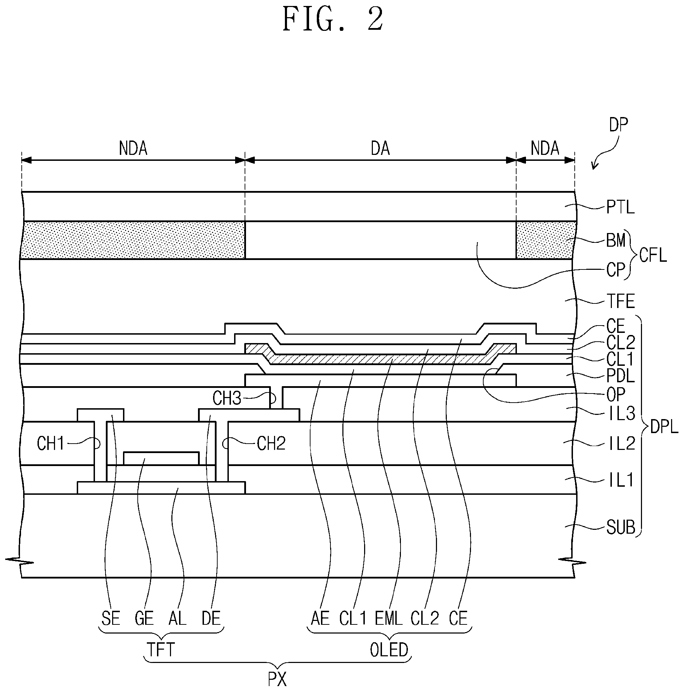

FIG. 1 is a schematic view of deposition equipment using a mask according to an embodiment of the inventive concept. FIG. 2 is a cross-sectional view illustrating a portion of a pixel area in a substrate according to an embodiment of the inventive concept. Referring to FIGS. 1 and 2, a mask and a display substrate provided by the mask will be described in more detail.

Deposition equipment 1000 includes a chamber 100, a substrate seat 200, a substrate 300, a mask frame 400, a deposition source 500, and a mask MS. The deposition equipment 1000 is used to provide a plurality of thin film patterns, which are included in a display device, on the substrate 300.

Inside the chamber 100, a space may be defined therein. The substrate seat 200, the substrate 300, the mask frame 400, the deposition source 500, and the mask MS may be disposed within the inner space. In the mask MS, an opening PO may be provided, and the opening PO corresponds to an area through which a deposition material DM is transferred.

The substrate 300 is disposed on (e.g., under) the substrate seat 200, and the substrate seat 200 supports the substrate 300. The substrate seat 200 may be provided in various forms as long as it has a general structure capable of supporting the substrate 300. For example, the substrate seat 300 may include a shuttle, an electrostatic chuck, or the like, which is disposed within the chamber 100.

The deposition material DM is deposited on the substrate 300 through the opening PO of the mask MS, and an area deposited with the deposition material DM may be defined as a pixel area DA that emits light. A non-pixel area NDA may be defined between adjacent pixel areas.

The mask frame 400 may be made of metal with high strength. Accordingly, the deformation of the mask frame 400, which may occur during welding, may be reduced, and thus a process may be stably performed, and a lifespan of the mask frame 400 may be increased.

In one embodiment, a welded portion, in which the mask frame 400 and the mask MS are welded and coupled, may be formed. A high temperature is generated around this welded portion, and thus the mask frame 400 may be made of a material having the low thermal deformation.

The deposition source 500 provides the deposition material DM to the substrate. The deposition source 500 may be provided with a set or predetermined inner space so as to accommodate the deposition material DM.

Here, the deposition material may be a material to be sublimated or vaporized, and include at least one of an inorganic substance, metal, or an organic substance. For example, a suctioning or vacuum part is operated after the chamber 100 is closed, and thus may maintain the pressure inside the chamber 100 in a substantially vacuum state. Also, the deposition source 500 may make the deposition material DM vaporized or sublimated, and accordingly, the deposition material DM passes through the mask MS and may be deposited on the substrate 300. Here, the deposition material passes through the opening PO in the mask MS, and thus may be deposited, on the substrate, in a regular pattern.

The deposition material DM is transferred through the mask MS and deposited on the substrate 300, and thus a deposition pattern EML is defined. The shape of the deposition pattern EML may correspond to the opening PO. The deposition pattern EML may be a light emitting pattern EML, which will be described later. Here, the deposition material DM may include a light emitting material. However, this is merely described as an example. Depending on the deposition material DM provided by the deposition source 500, the deposition pattern EML may be various suitable patterns that constitute a display panel DP that will be described later, and is not limited to one embodiment.

As illustrated in FIG. 2, the display panel DP includes a display layer DPL, a thin film encapsulation layer TFE, a color filter layer CFL, and a protection layer PTL.

The display layer DPL includes a base layer SUB, a pixel PX, and a plurality of insulation layers IL1, IL2, and IL3. The pixel PX includes a thin film transistor TFT and an organic light emitting element OLED.

The first insulation layer IL1 and a semiconductor pattern AL of the thin film transistor TFT are disposed on the base layer SUB. The first insulation layer IL1 covers the semiconductor pattern AL.

The second insulation layer IL2 and a control (e.g., gate) electrode GE of the thin film transistor TFT are disposed on the first insulation layer IL1. The second insulation layer IL2 covers the control electrode GE. Each of the first insulation layer IL1 and the second insulation layer IL2 includes an organic film and/or an inorganic film. Each of the first insulation layer IL1 and the second insulation layer IL2 may include a plurality of thin films.

The third insulation layer IL3, and input and output (e.g., source and drain) electrodes SE and DE of the thin film transistor TFT are disposed on the second insulation layer IL2. The third insulation layer IL3 covers the input and output electrodes SE and DE.

The input and output electrodes SE and DE are connected to the semiconductor pattern AL through first and second through-holes CH1 and CH2, which penetrate the first and second insulation layers IL1 and IL2, respectively. Here, this is merely illustrated as an example. A layer, in which the control electrode GE, the input electrode SE, the output electrode DE, and the semiconductor pattern AL are disposed, may be diversely or suitably changed. The control electrode GE, the input electrode SE, and the output electrode DE may directly contact the semiconductor AL without a separate through-hole. Thin film transistor TFT according to an embodiment of the inventive concept may be provided in various structures, and is not limited to any one embodiment.

The organic light emitting element OLED and a pixel defining film PDL are disposed on the third insulation layer IL3. The organic light emitting element OLED includes an anode electrode AE, a light emitting pattern EML, a cathode electrode CE, a hole transport region CL1 defined between the anode electrode AE and the light emitting pattern EML, and an electron transport region CL2 defined between the light emitting pattern EML and the cathode electrode CE. The anode electrode AE is provided in plurality, and each may be disposed to overlap a corresponding one of the pixel areas (along a thickness direction of the display panel DP).

The pixel defining film PDL is disposed on the anode electrode AE, and exposes a portion of the anode electrode AE. The pixel defining film PDL substantially defines the pixel area DA. Here, the anode electrode AE is connected to the output electrode DE through a third through-hole CH3 defined in the third insulation layer IL3.

The hole transport region CL1 is disposed on the anode electrode AE, and covers the anode electrode AE and the pixel defining film PDL. The hole transport region CL1 may include at least any one of a hole injection layer, a hole transport layer, or a single layer having both a hole injecting function and a hole transporting function.

The light emitting pattern EML is disposed on the hole transport region CL1. The light emitting pattern EML is provided in plurality, and each overlaps a corresponding one of light emitting areas (along a thickness direction of the display panel DP). The light emitting pattern EML may include a phosphorescent material and a fluorescent material. The light emitting pattern EML may generate light having one color, or light in which two or more colors are mixed.

According to an embodiment of the inventive concept, the substrate 300 provided to the deposition equipment 1000 may be supplied in a state in which layers up to the hole transport region CL1, which is a portion of the display layer DPL, are laminated. However, this is an example, and a lamination configuration of the substrate 300 provided to the deposition equipment 1000 is not limited to any one example.

The electron transport region CL2 is disposed on the light emitting pattern EML, and covers the light emitting pattern EML and the hole transport region CL1. The electron transport region CL2 may include at least any one of an electron transport material or an electron injection material. For example, the electron transport region CL2 may be an electron transport layer having the electron transport material, or an electron injection/transport single layer having the electron transport material and the electron injection material.

The cathode electrode CE is disposed on the electron transport region CL2, and faces the anode electrode AE. The cathode electrode CE may be made of a material having a low work function so as to enable easy electron injection.

The cathode electrode CE and the anode AE may be made of different materials, depending on a light emitting method. For example, when the pixel area DA according to the inventive concept is a front-light emitting type, the cathode electrode CE may be a transmissive electrode, and the anode electrode AE may be a reflective electrode.

Alternatively, for example, when the pixel area DA according to the inventive concept is a rear-light emitting type, the cathode electrode CE may be a reflective electrode, and the anode electrode AE may be a transmissive electrode. Here, positions of the cathode electrode CE and the anode electrode AE are not limited thereto, and may be suitably changed.

The pixel area DA according to the inventive concept may include organic light emitting elements having various suitable structures, and are not limited to any one embodiment.

The thin film encapsulation layer TFE is disposed on the cathode electrode CE. The thin film encapsulation layer TFE covers an entire surface of the cathode electrode CE, and encapsulates the organic light emitting element OLED. The thin film encapsulation layer TFE may have a thickness ranging from about 1 µm to about 10 µm. The pixel area DA includes the thin film encapsulation layer TFE, and thus a thin-film type pixel area DA may be realized.

The thin film encapsulation layer TFE may include a plurality of inorganic films and/or organic films. The inorganic films and the organic films may be alternately disposed. The inorganic film protects the organic light emitting element OLED against moisture/oxygen, and the organic film protects the organic light emitting element OLED against impurities such as dust particles. The inorganic film may include a nitride layer, a silicon oxynitride layer, a silicon oxide layer, a titanium oxide layer, an aluminum oxide layer, or the like. The organic film may include an acrylic-based organic film, but is not particularly limited thereto.

The color filter layer CFL includes a black matrix BM and color patterns CP. The black matrix BM and the color patterns CP are disposed on the same layer. The black matrix BM and the color patterns CP are directly disposed on the thin film encapsulation layer TFE, and contact a top surface of the thin film encapsulation layer TFE.

The black matrix BM may be made of a light blocking material. The black matrix BM absorbs light incident to the black matrix BM. Accordingly, the black matrix BM may have mainly a black-based color. The color patterns CP include color patterns having at least two different colors. The color patterns CP may have four or more colors, and portions of the adjacent color patterns may have the same color. The color filter layer CFL according to the inventive concept may include various embodiments, and is not limited to any one embodiment. Also, the color filter layer CFL may be omitted.

The protection layer PTL is disposed on the color filter layer CFL, and protects the color filter layer CFL. The protection layer PTL provides a flat surface in an upper portion. The flat surface corresponds to the front surface of the pixel area DA. However, this is merely illustrated as an example. The protection layer PTL may be omitted in the pixel area DA according to an embodiment of the inventive concept.

The mask MS illustrated in FIG. 1 may be applied to a process for manufacturing various suitable elements that constitute the pixel area DA. For example, the substrate 300 illustrated in FIG. 1 may be provided in a state in which the hole transport region CL1 is laminated to each region corresponding to the opening PO of the mask.

Then, the light emitting pattern EML is provided through the mask MS. Accordingly, the mask MS may be applied in a process of defining the light emitting pattern EML. However, this is merely disclosed as an example. The mask MS according to an embodiment of the inventive concept may be applied to various suitable processes, and is not limited thereto.

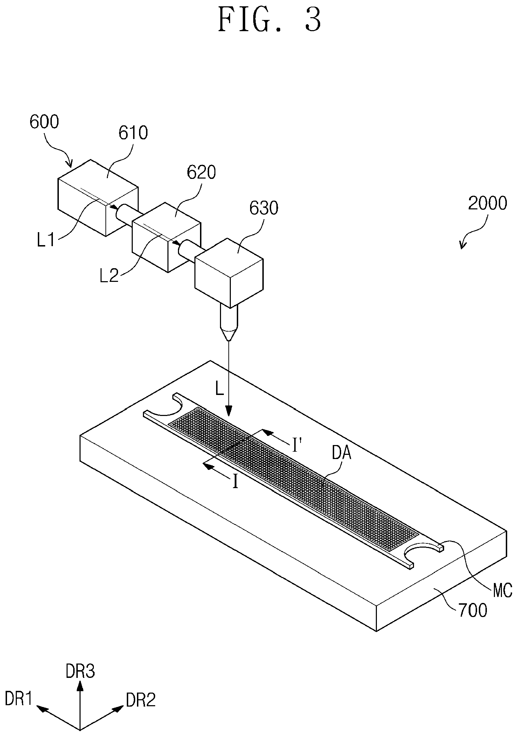

FIG. 3 is a perspective view of equipment for manufacturing a mask according to an embodiment of the inventive concept.

Referring to FIG. 3, a mask manufacturing apparatus 2000 includes a laser irradiation device 600, a stage 700, and a pre-mask MC. The mask manufacturing apparatus 2000 is equipment for manufacturing the mask MS (see FIG. 1) used in the deposition equipment 1000 (see FIG. 1), and may provide the mask MS by removing the front surface of the pre-mask MC. This will be described below in more detail.

The laser irradiation device 600 includes a laser generation member 610, an optical system 620, and a scanner 630. The laser irradiation device 600 may be provided on the stage 700. In one embodiment, the laser irradiation device 600 is connected to a separate moving unit that may move the laser irradiation device 600 on the stage 700, and may be installed on the stage 700.

The laser generation member 610 generates a first laser beam L1 that may melt or remove a portion of the pre-mask MC. The optical system 620 receives the first laser beam L1, and may control a shape of the first laser beam L1. For example, the first laser beam L1 provided from the laser generation member 610 is a laser beam having a Gaussian intensity profile, but a second laser beam L2, which is modified to have a uniform intensity distribution through the optical system 620, is provided. That is, for example, a uniform beam having a flat-top profile may be provided to the scanner 630. The optical system 620 may be constituted by a diffractive optical element (DOE) including a beam shaper that serves a beam shaping function.

Types of light irradiated to the pre-mask MC are not limited thereto, and a Gaussian optical system, a flat-top optical system, a line beam optical system, a multi beam optical system, or the like may be used.

The scanner 630 adjusts a reflection direction such that the second laser beam L2 provided from the optical system 620 may be irradiated to the mask MC. The scanner 630 may be described later in more detail.

According to an embodiment of the inventive concept, a laser beam L irradiated to the pre-mask MC may be an ultra-short pulsed laser in which a wavelength of transmitted light is extremely short. For example, the laser beam L may be a pico-second or a femto-second laser. Accordingly, pattern machining for a very precise unit may be easily performed using the laser beam L.

The pre-mask MC may be made of a thin plate of an invar material. For example, the invar material is an alloy having 64% of iron (Fe) and 36% of nickel (Ni), and it is a material having a very low coefficient of thermal expansion.

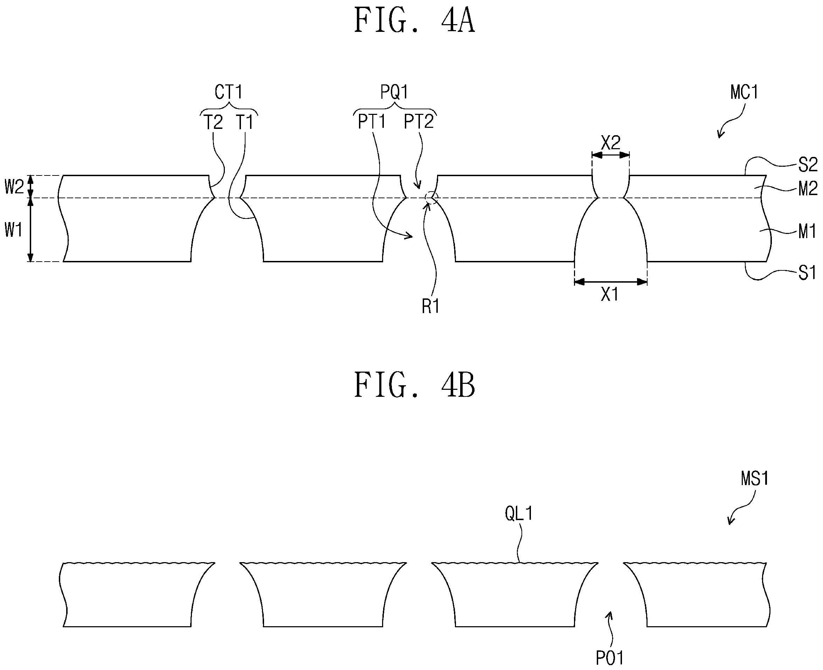

FIGS. 4A and 4B are cross-sectional views of a mask according to an embodiment of the inventive concept. FIG. 4A illustrates a cross-sectional view taken along line I-I' of the pre-mask MC illustrated in FIG. 3. FIG. 4B illustrates a cross-sectional view of a mask MS. The mask MS may be provided by the laser machining of the pre-mask MC through the laser irradiation device 600.

A pre-mask MC1 includes a pattern portion PQ1. The pattern portion PQ1 includes a first pattern groove PT1 defined on the front surface of the pre-mask MC1, and a second pattern groove PT2 defined on a rear surface corresponding to the front surface. The first pattern groove PT1 and the second pattern groove PT2 may be provided in plurality to the pre-mask MC1. The first pattern groove PT1 and the second pattern groove PT2 are disposed to overlap each other, and pass through the pre-mask MC1 to define the pattern portion PQ1.

The first pattern groove PT1 and the second pattern groove PT2 according to an embodiment of the inventive concept are illustrated to have inner surfaces of which shapes have curved lines on a cross-section. The inner surface of the first pattern groove PT1 has a first curved surface T1, and the inner surface of the second pattern groove PT2 has a second curved surface T2. A protrusion R1 is defined at the portion where the first curved surface T1 directly contacts (meets) the second curved surface T2.

The first pattern groove PT1 and the second pattern groove PT2 have widths that decrease gradually from the front surface and the rear surface, respectively, toward the protrusion R1 of the pre-mask MC1. Also, each of the first curved surface T1 and the second curved surface T2 has a radius of curvature that decreases gradually as it approaches the protrusion R1.

The first pattern groove PT1 has a first width X1, and the second pattern groove PT2 has a second width X2. The first width X1 and the second width X2 may be defined as maximum widths of the first pattern groove PT1 and the second pattern groove PT2, respectively. The first width X1 may be measured on the same plane as a first surface S1, and the second width X2 may be measured on the same plane as a second surface S2 corresponding to the first surface S1. The first width X1 may be equal to or greater than the second width X2.

The thickness of the pre-mask MC1 may be defined by the sum of a first thickness W1 corresponding to the depth of the first pattern groove PT1 in the thickness direction from the first surface S1, and a second thickness W2 corresponding to the depth of the second pattern groove PT2 in the thickness direction from the second surface S2. The thickness of a first portion M1 may be equal to or greater than the thickness of a second portion M2.

The pre-mask MC1 according to an embodiment of the inventive concept may have the thickness ranging from about 10 µm to about 100 µm. When the thickness of the pre-mask MC1 is about 10 µm or less, it may be difficult to provide an opening that satisfies an intended deposition area. Also, since a processed depth is from about 1 µm to about 4 µm during the machining using the ultra-short pulsed laser, it is desirable for the machining process efficiency that the thickness of the pre-mask MC1 is less than about 100 µm.

The first pattern groove PT1 may have the first width X1 ranging form about 15 µm to about 40 µm. When the first width X1 is about 15 µm or less, a section of the pixel area DA may be narrowly provided, which causes a defect in which the deposition material is not deposited. When the first width X1 is about 40 µm or more, a color mixing defect may occur between the adjacent pixels PX.

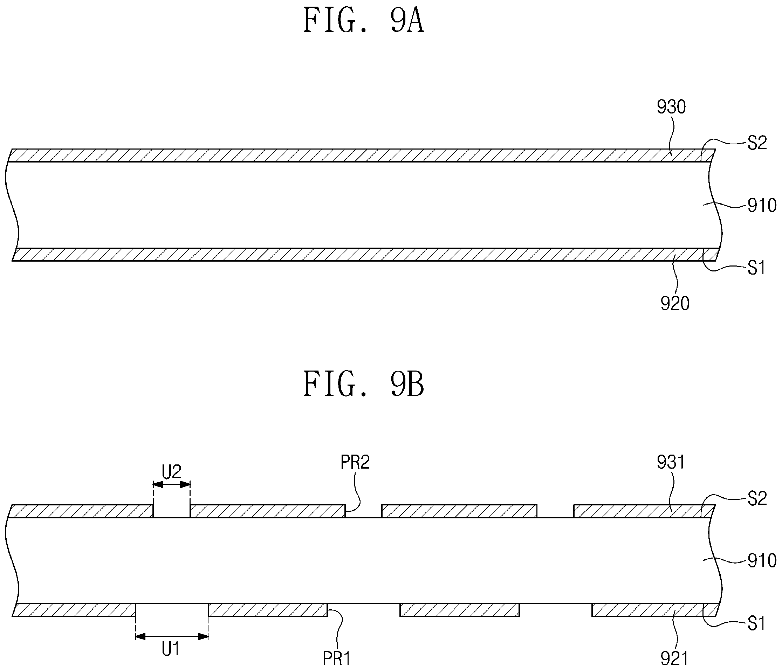

The protrusion R1 of the pre-mask MC1 is created during etching processes for the first surface S1 and the second surface S2 of the pre-mask MC1 (see FIGS. 9A to 9D), and may be provided as the first pattern groove PT1 and the second pattern groove PT2 having different widths that overlap each other in the thickness direction of the pre-mask MC1. That is, the protrusion R1 is produced, as the plurality of pattern grooves overlap each other in the thickness direction.

There may be a shadow defect in which, during the deposition process, a deposition area is expanded due to the protrusion R1 and thus a deposition area for emitting another light is breached. As a result, when a mask having the above-described pre-mask MC1 is used in the deposition process, the quality degradation of the display device, such as the manufacture of defective products, may be caused.

The equipment for manufacturing the mask according to an embodiment of the inventive concept aims to remedy the shadow defect. The front surface of the pre-mask MC1 is removed through the irradiation of the laser beam L (see FIG. 3), and a mask having an opening, in which the protrusion is removed, is provided.

As illustrated in FIG. 4B, the cross-sectional view of the mask MS1, which is provided after irradiating the laser beam L to the second surface S2 of the pre-mask MC1 of FIG. 4A, is illustrated. For example, the laser beam L (see FIG. 3) is irradiated to at least one portion of the first portion M1 or the second portion M2 of the pre-mask MC1, and thus at least one portion thereof may be removed. In the cross-sectional view, the mask MS1 according to an embodiment of the inventive concept, in which the second portion M2 of the pre-mask MC1 is removed, is illustrated.

The surface, which is removed by the laser beam L, has an uneven surface shape QL1. The surface, which is not removed by the laser beam L, i.e., the surface corresponding to the first surface S1 of the pre-mask MC1 is not damaged by the laser beam L, and this surface may have a relatively even surface shape.

The protrusion R1 of the pre-mask MC1 is removed by the laser beam L (see FIG. 3), and thus the mask MS1 may have an opening P01 corresponding to the first pattern groove PT1. The opening PO1 corresponds to the pixel area DA (see FIG. 2) of the substrate 300 (see FIG. 1), and is an area through which the deposition material is transferred.

The mask MS1, which is provided by the mask manufacturing apparatus 2000 according to an embodiment of the inventive concept, enables the application of the deposition material to the desired position and with the desired size, by removing the protrusion R1 included in the pre-mask MC1. Therefore, the shadow defect that occurs during the deposition process may be reduced.

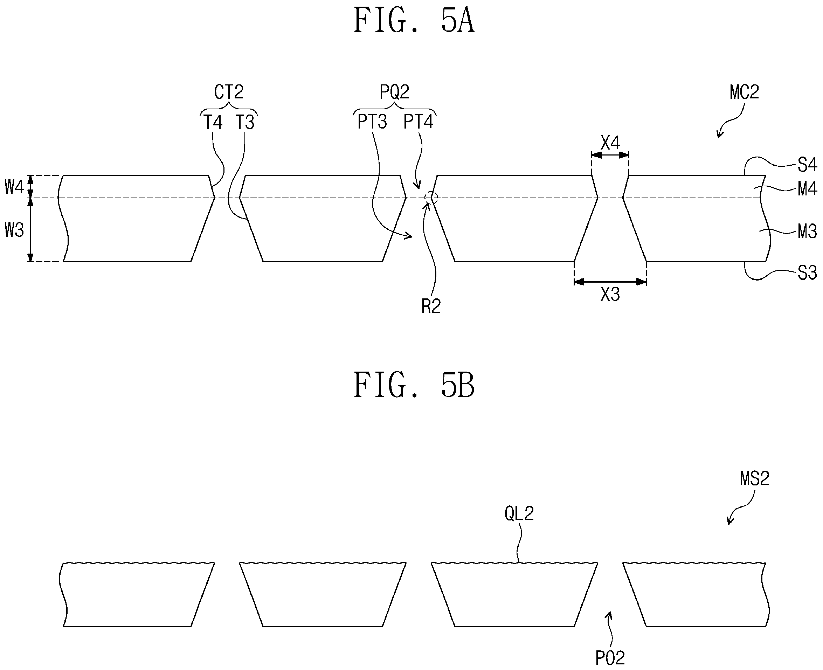

FIGS. 5A and 5B are cross-sectional views of a mask according to an embodiment of the inventive concept. The reference symbols, similar to those of FIGS. 4A and 4B described above, are used, and their duplicated descriptions may not be provided again.

A pre-mask MC2 includes a pattern portion PQ2. The pattern portion PQ2 includes a first pattern groove PT3 defined on a first surface S3 of a pre-mask MC2, and a second pattern groove PT4 defined on a second surface S4 corresponding to the first surface S3. The first pattern groove PT3 and the second pattern groove PT4 may be provided in plurality to the pre-mask MC2. The first pattern groove PT3 and the second pattern groove PT4 are disposed to overlap each other, and pass through the pre-mask MC2 to define a pattern portion PQ2. The inner surface of the first pattern groove PT3 has a first inclined surface T3, and the inner surface of the second pattern groove PT4 has a second inclined surface T4. A protrusion R2 is defined at the portion where the first inclined surface T3 directly contacts the second inclined surface T4.

The first pattern groove PT3 and the second pattern groove PT4 have widths that decrease gradually from the front surface and the rear surface, respectively, toward the protrusion R2 of the pre-mask MC2.

The first pattern groove PT3 has a first width X3, and the second pattern groove PT4 has a second width X4. The first width X3 may be equal to or greater than the second width X4. The first pattern groove PT3 and the second pattern groove PT4 according to an embodiment of the inventive concept are illustrated to have inner surfaces of which shapes have inclined lines on a cross-section.

The thickness of the pre-mask MC2 may be defined by the sum of a first thickness W3 corresponding to the depth of the first pattern groove PT3, and a second thickness W4 corresponding to the depth of the second pattern groove PT4. The first thickness W3 may be equal to or greater than the second thickness W4.

As illustrated in FIG. 5B, the cross-sectional view of the mask MS2, which is provided after irradiating the laser beam L (see FIG. 3) to the second surface S4 of the pre-mask MC2 of FIG. 5A, is illustrated. For example, the laser beam L is irradiated to at least one portion of the first portion M3 or the second portion M4 of the pre-mask MC2, and thus at least one portion thereof may be removed. In the cross-sectional view, the mask MS2 according to an embodiment of the inventive concept, in which the second portion M4 of the pre-mask MC2 is removed, is illustrated. In the mask MS2, the surface, which is removed by the laser beam L, has an uneven surface shape QL2.

The surface, which is not removed by the laser beam L, i.e., the surface corresponding to the first surface S3 of the pre-mask MC2 is not damaged by the laser beam L, and this surface may have a relatively even surface shape.

The protrusion R2 of the pre-mask MC2 is removed by the laser beam L, and thus the mask MS2 may have an opening PO2 corresponding to the first pattern groove PT3. The opening PO2 corresponds to the pixel area DA of the substrate 300 (see FIG. 1), and is an area through which the deposition material is transferred.

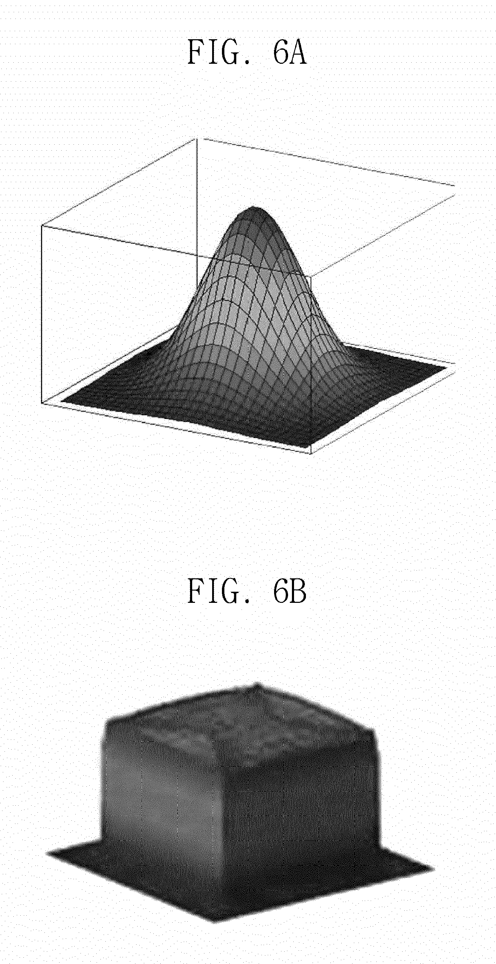

FIG. 6A is a graph illustrating a probability density distribution of the first laser beam L1 (the laser beam generated in the laser generation member 610), and FIG. 6B is a graph illustrating a probability density distribution of the second laser beam L2 (the laser beam emitted from the optical system 620).

Referring to FIG. 6A, the first laser beam L1 (see FIG. 3), for example, the Gaussian laser beam has an end portion with a convex shape. Therefore, in the case in which the Gaussian laser beam is irradiated to a front surface of the pre-mask MC (see FIG. 3) several times while moving in a predetermined direction, the surface to be melted may be uneven. Also, since a direct contact area is small, the processing time required to remove a set or predetermined thickness of the pre-mask MC may increase.

Referring to FIG. 6B, the second laser beam L2 (see FIG. 3), for example, the flat-top beam has an end portion with an even surface shape when compared to the shape of the Gaussian laser beam. Through the optical system 630 (see FIG. 3), the first laser beam L1 (the Gaussian shaped laser beam) is transformed into the second laser beam L2 (the flat-top shaped laser beam), and thus may be irradiated to the pre-mask MC.

The optical system 620 used in the mask manufacturing apparatus 2000 (see FIG. 3) may be constituted by, for example, a diffractive optical element (DOE) including a configuration for the beam shaping function. The mask manufacturing apparatus 2000 according to the inventive concept uses the optical system 620, and thus may be used to transform the Gaussian shaped laser beam produced in the laser generation member 610 into the flat-top shaped laser beam, thereby manufacturing the mask MS (see FIG. 1) using the pre-mask MC.

Since the flat-top laser beam has the end portion with the flat surface, when it is irradiated to the pre-mask MC, a relatively uniform surface is generated, compared to the shape of Gaussian laser beam, and thus the front surface of the pre-mask MC may be removed. Also, since the area directly contacting the front surface of the pre-mask MC becomes relatively wide, the processing time required to remove a preset or predetermined thickness of the pre-mask MC may be relatively short.

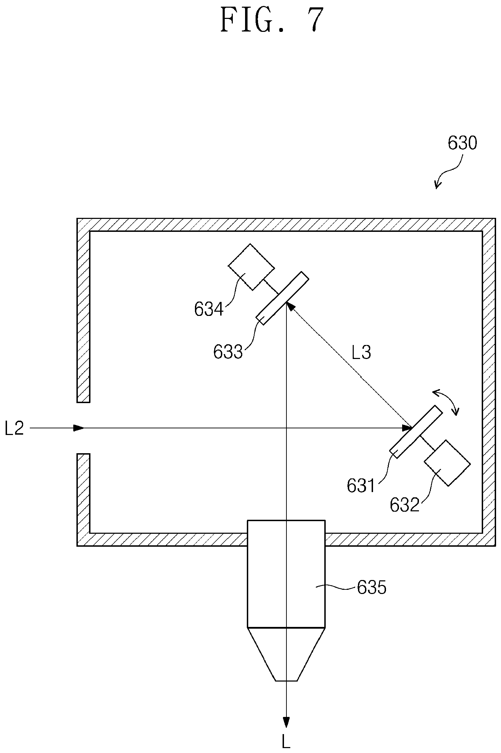

FIG. 7 is a cross-sectional view of a scanner according to an embodiment of the inventive concept.

As illustrated in FIG. 7, the scanner 630 may be provided with a first mirror 631, a first driving part 632, a second mirror 633, a second driving part 634, and a lens part 635.

The second laser beam L2 provided through the optical system 620 (see FIG. 3) is incident to the scanner 630, and then reflected from the first mirror 631. A third laser beam L3 reflected from the first mirror 631 faces toward the second mirror 633. The second mirror 633 reflects again the third laser beam L3 reflected from the first mirror 631, and then irradiates the reflected laser beam to the pre-mask MC (FIG. 3). The first mirror 631 and the second mirror 633 are driven by the first driving part 632 and the second driving part 634, respectively. That is, the first driving part 632 rotates the first mirror 631, and thus changes the reflection direction of the second laser beam L2 incident to the first mirror 631. Also, the second driving part 634 rotates the second mirror 633, and thus changes the reflection direction of the third laser beam L3 reflected from the first mirror 631. The first driving part 632 and the second driving part 634 may rotate the first mirror 631 and the second mirror 633, respectively, in different directions. The laser beam L may be irradiated onto the pre-mask MC (see FIG. 3) while being steered in a first direction DR1 (see FIG. 3) and a second direction DR2 (see FIG. 3) of the pre-mask MC (e.g., by changing its reflection direction from within the scanner 630) to remove an incident surface portion of the pre-mask MC.

The lens part 635 functions as collecting the laser beam L reflected from the second mirror 633. The lens part 635 may be disposed under the scanner 630 such that the laser beam L is collected and directed toward the pre-mask MC.

The first mirror 631, the second mirror 633, the first driving part 632, and the second driving part 634 of the scanner 630 according to an embodiment of the inventive concept may be provided as a galvano scanner. Since provided as the galvano scanner, it is possible to control the direction of the laser beam L, which is provided from the optical system 620 (see FIG. 3), by the mirror and the driving parts, which can allow the removal process of the front surface of the pre-mask MC (see FIG. 3) to be more precisely performed.

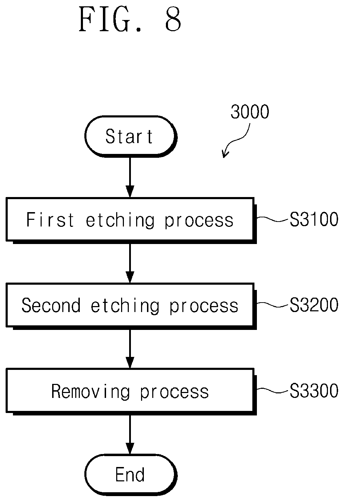

FIG. 8 is a block diagram illustrating a method for manufacturing a mask according to an embodiment of the inventive concept. FIGS. 9A to 9F are views illustrating a process of a method for manufacturing a mask according to an embodiment of the inventive concept. The reference symbols, similar to those of FIGS. 3 to 4B, are used, and their duplicated descriptions will be omitted.

As illustrated in FIG. 8, a mask manufacturing method (3000) includes a first etching process (S3100), a second etching process (S3200), and a removing process (S3300). The first etching process (S3100) and the second etching process (S3200) are processes that provide a pre-mask, and the removing process (S3300) is a process that removes a portion of the pre-mask to provide a mask. Hereinafter, the mask manufacturing method will be described in more detail with reference to FIGS. 9A to 9F.

FIG. 9A to 9D illustrate processes corresponding to the first etching process (S3100) and the second etching process (S3200). As illustrated in FIG. 9A, a first photoresist layer 920 and a second photoresist layer 930 are applied to a first surface S1 and a second surface S2 that corresponds to the first surface S1, respectively, in an initial mask 910. As one example, the initial mask 910 may be made of a thin plate of an invar material. Here, the invar material is an alloy having 64% of Fe and 36% of Ni, and it is a material having a very low coefficient of thermal expansion.

Then, as illustrated in FIG, 9B, a photolithography process is performed on the initial mask 910, and thus a first pattern PR1 and a second pattern PR2 is provided in a first photoresist layer 921 and a second photoresist layer 931, respectively. The first pattern PR1 may have a width U1 that is greater than a width U2 of the second pattern PR2.

First, the photolithography process starts with aligning photo-masks that have a plurality of openings with shapes corresponding to patterns that would be defined by the photoresist layers.

The photo-masks corresponding to photoresist layers, respectively, are aligned. Then, a light exposure process, in which portions of the photoresist layers blocked by the photo-masks are exposed to light, and a developing process, in which the photoresist layers are etched, are performed, and thus the plurality of patterns may be provided. The photoresist layers may be provided by applying photoresist solutions on the initial mask 910 through various methods such as a spincoating, a spraying, or a quenching method. In one embodiment, the spincoating method is used, which can uniformly apply the photoresist solution even to a large sized substrate.

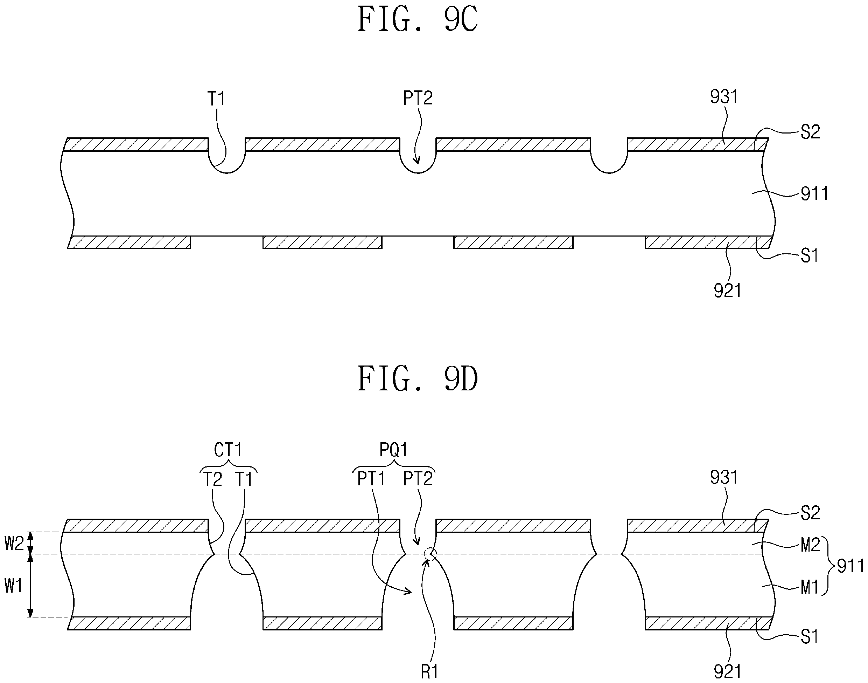

Then, as illustrated in FIGS. 9C and 9D, each portion of the first surface S1 and the second surface S2 of the pre-mask 911 exposed by the first pattern PR1 and the second pattern PR2 is wet-etched, and thus a first pattern groove PT1 and a second pattern groove PT2 are provided through the first surface S1 and the second surface S2 of the pre-mask 911, respectively. Here, the width of the first pattern groove PT1 is greater than that of the second pattern groove PT2. The first pattern groove PT1 and the second pattern groove PT2 are provided to overlap each other, and pass through the pre-mask 911 to define a pattern portion PQ1. Through the wetetching process, the inner surface of the first pattern groove PT1 has a first curved surface T1, and the inner surface of the second pattern groove PT2 has a second curved surface T2. A protrusion R1 is defined at the portion where the first curved surface T1 directly contacts or meets the second curved surface T2.

The first pattern groove PT1 and the second pattern groove PT2 have widths that decrease gradually from the first surface S1 and the second surface S2, respectively, toward the protrusion R1 of the pre-mask 911.

After the first pattern groove PT1 and the second pattern groove PT2 are defined, the pre-mask 911 is washed, and then the first photoresist layer 921 and the second photoresist layer 931 may be removed.

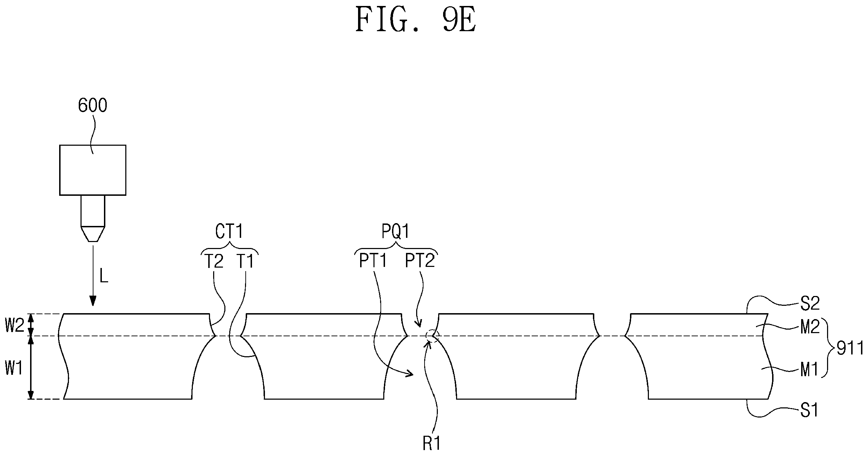

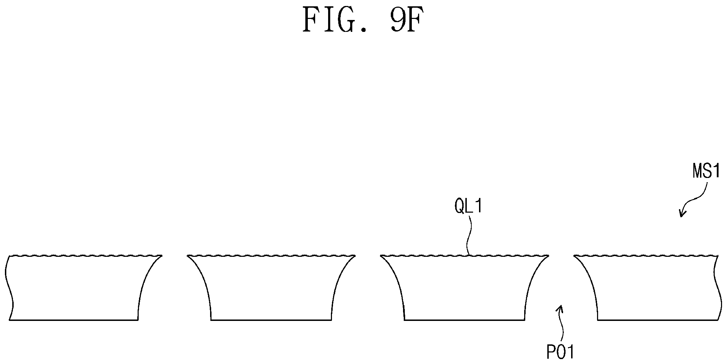

As illustrated in FIGS. 9E and 9F, a laser beam L generated in a laser irradiation device 600 is irradiated to a rear surface of the pre-mask 911, in which the second pattern groove PT2 is defined, i.e., the second surface S2 of the pre-mask 911. This laser beam L is uniformly irradiated to the rear surface of the pre-mask 911 such that a second portion M2 of the pre-mask 911 is removed. After the second portion M2 is all removed, a mask MS1 used in the deposition equipment 1000 (see FIG. 1) is completed.

The protrusion R1 of the pre-mask 911 is removed by the laser beam L, and thus the mask MS1 may have an opening PO1 corresponding to the first pattern groove PT1. The opening PO1 corresponds to the pixel area DA (see FIG. 3) of the substrate 300 (see FIG. 1), and is an area through which the deposition material is transferred.

The surface, which is removed by the laser beam L, has an uneven surface shape QL1. The surface, which is not removed by the laser beam L, i.e., the surface corresponding to the first surface S1 of the pre-mask 911 is not damaged by the laser beam L, and this surface may have a relatively even surface shape.

In the mask manufacturing method according to an embodiment of the inventive concept, the mask MS1, in which the protrusion R1 is removed, is provided, and the deposition material is uniformly deposited through the opening PO1 of the mask MS1 during the deposition, which may provide the display device having improved quality.

According to an embodiment of the inventive concept, the deposition material is uniformly deposited to the display substrate through the opening of the mask during the deposition, which may provide the display device having improved quality.

The mask manufacturing apparatus and/or any other relevant devices or components according to embodiments of the present invention described herein may be implemented utilizing any suitable hardware, firmware (e.g. an application-specific integrated circuit), software, or a combination of software, firmware, and hardware. For example, the various components of a controller for the manufacturing apparatus or the laser irradiation device may be formed on one integrated circuit (IC) chip or on separate IC chips. Further, the various components of the controller may be implemented on a flexible printed circuit film, a tape carrier package (TCP), a printed circuit board (PCB), or formed on one substrate. Further, the various components of the controller may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, or the like. Also, a person of skill in the art should recognize that the functionality of various computing devices may be combined or integrated into a single computing device, or the functionality of a particular computing device may be distributed across one or more other computing devices without departing from the scope of the exemplary embodiments of the present invention.

While specific terms were used herein, they were not used to limit the meaning or the scope of the present invention described in the claims but merely used to explain an embodiment of the inventive concept. Accordingly, a person having ordinary skill in the art will understand that various modifications and other equivalent embodiments are also possible. Hence, the real scope of the present invention shall be determined by the scope of the accompanying claims.

## Claims

1. An apparatus for manufacturing a mask, the apparatus comprising:
a stage on which a pre-mask is disposed such that a front surface of the pre-mask faces the stage; and
a laser irradiation device comprising a laser generation member configured to irradiate a laser beam to remove a portion of the pre-mask, an optical system configured to receive the laser beam and control a shape of the laser beam, and a scanner configured to adjust a path of the laser beam that has the shape controlled by the optical system,
the pre-mask comprising a first portion having a first pattern groove provided through the front surface and a second portion having a second pattern groove provided through a rear surface that faces oppositely away from the front surface, the first portion and the second portion being arranged in a first direction that is a thickness direction of the pre-mask, and
the laser irradiation device being configured to irradiate a beam with the controlled shape onto the second portion of the pre-mask such that it is steered in a second direction crossing the first direction to remove the second portion to provide a mask having an opening.

2. Apparatus according to claim 1, wherein a width of the first pattern groove is greater than a width of the second pattern groove.

3. Apparatus according to claim 1 or 2, wherein a width of the first pattern groove has a maximum width ranging from about 15 µm to about 40 µm.

4. Apparatus according to any preceding claim, wherein the first pattern groove and the second pattern groove respectively have widths that decrease gradually from the front surface and the rear surface of the pre-mask in the thickness direction of the pre-mask.

5. Apparatus according to any preceding claim, wherein a surface of the mask exposed by removing the second portion has an uneven surface shape.

6. Apparatus according to any preceding claim, wherein
a shape of an inner surface on a cross-section of each of the first pattern groove and the second pattern groove is formed of either a curved line or a straight line.

7. An apparatus for manufacturing a mask, the apparatus comprising:
a stage on which a pre-mask having a first thickness is disposed, the pre-mask having a first surface and a second surface that face oppositely away from each other; and
a laser irradiation device comprising a laser generation member configured to irradiate a laser beam to remove a portion of the pre-mask, an optical system configured to receive the laser beam and control a shape of the laser beam, and a scanner configured to adjust a path of the laser beam that has the shape controlled by the optical system,
the pre-mask comprising a pattern portion having a protrusion, the pattern portion being provided in a first direction that is a thickness direction of the pre-mask, and
the laser irradiation apparatus being configured to irradiate the laser beam with the controlled shape on any one of the first surface and the second surface of the pre-mask to provide a mask having a second thickness different from the first thickness and having an opening in which the protrusion is removed.

8. Apparatus according to claim 7, wherein the first thickness is greater than the second thickness.

9. Apparatus according to claim 7 or 8, wherein a width of the opening has a maximum width ranging from about 15 µm to about 40 µm.

10. Apparatus according to claim 7, 8 or 9 wherein
a shape of an inner surface of the pattern portion on a cross-section is formed of either a curved line or a straight line.

11. Apparatus according to claim 10, wherein,
when the shape of the inner surface on a cross section of the pattern portion is a curved line, a radius of curvature decreases gradually from each of the first surface and the second surface of the mask toward the protrusion.

12. Apparatus according to one of claims 7 to 11, wherein a surface of the mask exposed by removing the protrusion has an uneven surface shape.

13. Apparatus according to any preceding claim, wherein the laser beam is a femto-second laser beam.

14. Apparatus according to any preceding claim, wherein the laser beam with the controlled shape has a flat-top shape.

15. Apparatus according to any preceding claim, wherein the scanner comprises:
a first mirror configured to reflect the laser beam with the controlled shape;
a first driving part configured to rotate the first mirror;
a second mirror configured to transmit the laser beam with the controlled shape, which is reflected from the first mirror, to the pre-mask;
a second driving part configured to rotate the second mirror; and
a lens configured to collect the laser beam with the controlled shape, which is reflected from the second mirror.

16. A method for manufacturing a mask, the method comprising:
performing a first etching in which, for a pre-mask having a first surface and a second surface that face oppositely away from each other, a first pattern groove having a first depth is provided through the first surface;
performing a second etching in which a second pattern groove having a second depth is provided through the second surface; and
providing a mask that has a front surface having an even surface shape and a rear surface having an uneven surface shape, by removing any one of the first surface and the second surface of the pre-mask,
wherein the rear surface is defined by removing any one of the first surface and the second surface.

17. A method according to claim 16, wherein the providing of the mask comprises irradiating a laser beam onto the front surface of the pre-mask and removing any one of the first surface and the second surface of the pre-mask.
